# FASCICULE DE BREVET EUROPEEN

(11) **EP 1 417 505 B1**
(45) Date de publication et mention de la délivrance du brevet: **01.12.2004**
(21) Numéro de dépôt: 02794811.6
(22) Date de dépôt: 13.08.2002
(51) Int. Cl.: G01R 33/04

(54) **MAGNETOMETRE A CORRECTION DE DISSYMETRIE DE STRUCTURE**
MAGNETOMETER MIT STRUKTURASYMMETRIEKORREKTUR
MAGNETOMETER WITH STRUCTURE ASYMMETRY CORRECTION

(30) Priorité: 16.08.2001 FR 0110851
(43) Date de publication de la demande: 12.05.2004
(73) Titulaire: COMMISSARIAT A L'ENERGIE ATOMIQUE, 75752 Paris Cédex 15 (FR)
(72) Inventeur: LEGER, Jean-Michel, F-38190 Villard-Bonnot (FR); GUILHAMAT, Bernard, F-38590 Saint Michel de Saint Geoirs (FR)
(74) Mandataire: Poulin, Gérard
(86) Numéro de dépôt international: PCT/FR2002/002870
(87) Numéro de publication internationale: WO 2003/016934

(56) Documents cités:
- US-A- 3 731 752
- US-A- 4 514 689
- US-A- 5 134 370
- LIAKOPOULOS T M ET AL: "A micro-fluxgate magnetic sensor using micromachined planar solenoid coils" SENSORS AND ACTUATORS A, ELSEVIER SEQUOIA S.A., LAUSANNE, CH, vol. 77, no. 1, 28 septembre 1999 (1999-09-28), pages 66-72, XP004244548 ISSN: 0924-4247

## Description

Le sujet de cette invention est un magnétomètre dont les dissymétries de structure sont corrigées.

Les magnétomètres de type à porte de flux (« fluxgate ») à structure différentielle (décrits par exemple dans US 3 731 752 A) comprennent un noyau magnétique, au moins un bobinage actif et un bobinage récepteur qui comprend deux enroulements disposés en série autour du noyau de manière que le champ magnétique produit par un courant d'excitation dans le bobinage actif crée des inductions opposées dans les enroulements du bobinage récepteur, et des courants induits qui s'annulent puisqu'ils sont aussi opposés. Ils réagissent alors à des champs magnétiques ambiants par un courant d'induction ayant une fréquence double de la fréquence d'excitation pour peu que le courant d'excitation des bobinages actifs soit suffisant. La tension ainsi induite aux bornes du bobinage récepteur est recueillie et mesurée par des moyens de mesure.

Ces magnétomètres présentent un biais (erreur de mesure, mise en évidence lorsque l'instrument est mis en oeuvre en champ nul) variable d'un appareil à l'autre, ce qui dégrade leur précision et limite donc leur usage dans les applications de métrologie des champs continus. De plus pour un magnétomètre donné, ce biais évolue par exemple en fonction de la température.

Une des contributions au biais est liée, dans le cas de la structure différentielle, au résidu de la fréquence d'excitation présent aux bornes des bobinages récepteurs du fait des dissymétries entre les deux branches de mesure ou d'excitation. Lorsque le magnétomètre est alors opéré en mode de compensation de champ (configuration classique en boucle fermée qui permet notamment d'en étendre la linéarité), ceci a pour effet de réinjecter dans les deux branches du circuit magnétique une composante synchrone de la fréquence d'excitation mais déphasée par rapport à cette dernière.

Des dissymétries du magnétomètre consistent en des irrégularités de diamètre du fil ou des spires, voire du nombre de spires, entre les enroulements du bobinage récepteur ou encore leurs positions relatives vis-à-vis des bobines d'excitation, qui influent sur la mutuelle inductrice entre les bobinages d'excitation et d'induction.

On a donc cherché à restaurer l'équilibre du magnétomètre par un dispositif, intégré à un circuit de détection perfectionné, qui corrige l'induction non nulle à la fréquence d'excitation et les mesures qui sont alors produites. L'invention est ainsi relative à un magnétomètre comprenant un noyau magnétique, au moins un bobinage actif et un bobinage récepteur, le bobinage actif étant agencé de façon à créer un champ magnétique d'excitation dans le noyau, le bobinage récepteur ayant deux enroulements, des moyens de passage d'un courant alternatif à une fréquence d'excitation dans le bobinage actif et des moyens de mesure d'une tension induite dans le bobinage récepteur, caractérisé en ce que les moyens de mesure comprennent un détecteur d'une composante synchrone à la fréquence d'excitation de la tension induite, un circuit à deux boucles dont chacune comprend un des enroulements du bobinage récepteur, un sommateur de tensions partielles aux bornes des deux boucles et un dispositif de correction d'une desdites tensions partielles, asservi audit détecteur.

Outre la réduction du biais, qui donne une mesure stable à champ nul, pour de longues mesures et même quand la température varie, on obtient des bandes passantes plus élevées.

Le dispositif de correction peut être une résistance variable.

L'invention sera maintenant décrite complètement en liaison aux figures suivantes :
- la figure 1 est une représentation d'un magnétomètre différentiel,
- et la figure 2 représente le circuit de mesure complété d'après l'invention.

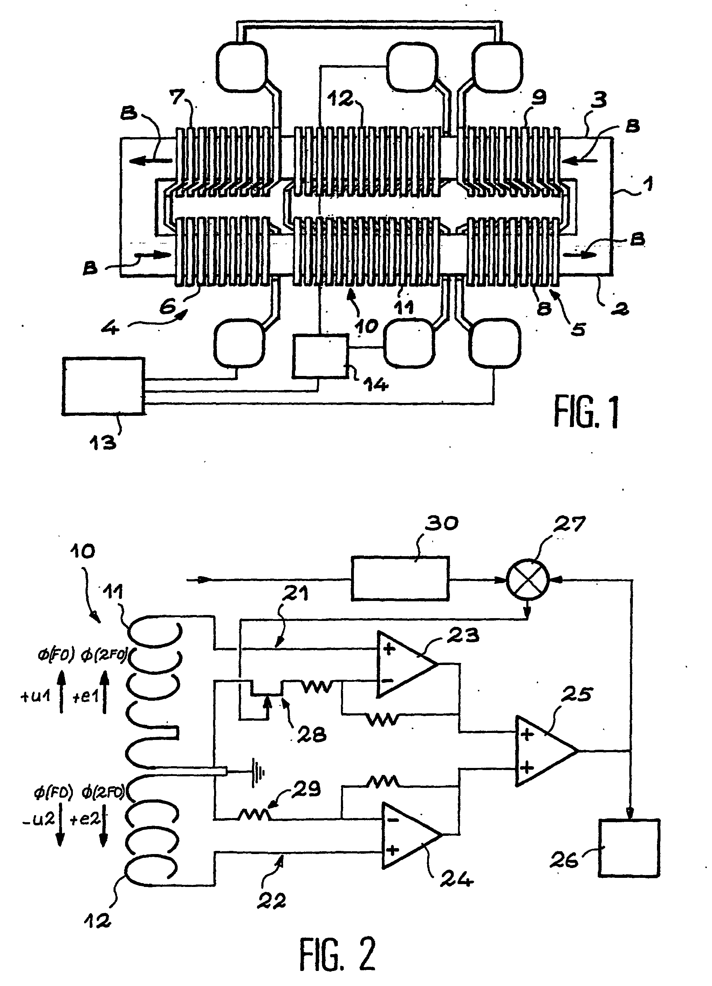

Le magnétomètre différentiel de la figure 1 est du genre le plus fréquent et comprend un noyau magnétique 1 avec au moins deux branches principales 2 et 3. Trois bobinages sont enroulés autour du noyau 1, et plus précisément deux bobinages actifs 4 et 5 comprenant chacun deux enroulements 6, 7 et 8, 9 autour respectivement des branches 2 et 3, ainsi qu'un bobinage récepteur 10 composé de deux enroulements 11 et 12 encore autour des branches 2 et 3 respectivement. Les bobinages 4 et 5 actifs sont reliés de telle manière que le champ magnétique d'excitation circule en sens inverse dans les deux branches principales 2 et 3 dans un circuit aboutissant à un dispositif d'excitation 13, et le bobinage récepteur est aux bornes d'un dispositif de mesure 14.

Les enroulements 6 et 8 sont formés dans un même sens autour de la branche 2, et les enroulements 7 et 9 dans un sens opposé autour de l'autre branche 3 de manière à créer un champ magnétique B apte à circuler dans le noyau magnétique lorsque celui-ci est fermé comme c'est le cas ici où deux branches courtes du noyau magnétique 1 relient les branches principales 2 et 3. le noyau magnétique 1 pourrait cependant être ouvert.

Les moyens d'excitation sont aptes à fournir un courant d'excitation à une fréquence déterminée et peuvent comprendre un oscillateur, un diviseur de fréquence par deux, un convertisseur d'onde carrée en onde triangulaire et un convertisseur de tension en courant. Les moyens de mesure 14 comprennent un préamplificateur recueillant la tension aux bornes du bobinage récepteur 10, un détecteur synchrone alimenté par le signal de l'oscillateur non divisé par deux, un filtre passe-bas, un correcteur proportionnel-intégral-différentiel, un amplificateur, un filtre passe-bas à fréquence de coupure par exemple de l'ordre d'un hertz et des moyens d'affichage. Un courant de contre-réaction peut être appliqué aux bornes du bobinage de mesure 10 en prélevant la tension à la sortie du module de correction et en la convertissant en courant. On ne s'étendra pas plus sur ces éléments déjà divulgués et d'ailleurs assez simples, et qui permettent de prélever le signal induit à une fréquence double de la fréquence d'excitation et de le convertir en signal continu avant de le transmettre aux moyens d'affichage, qui le mesurent.

Le flux magnétique produit par le champ magnétique de circulation φ(F₀) produit des tensions induites dans chacun des enroulements 11 et 12, respectivement u1 et u2, et le champ magnétique à mesurer φ(2F₀) des tensions induites e1 et e2. La tension u2 est opposée aux autres de sorte que la tension totale induite aux bornes du bobinage récepteur 10 est égale à u1-u2+e1+e2. Comme on l'a vu, la dissymétrie des enroulements 11 et 12 fait que u1 et u2 sont généralement différents, de même que e1 et e2. Le dispositif de mesure 14 est donc complété de la façon suivante qu'on détaille à la figure 2. Deux boucles de circuit 21 et 22 relient les bornes positives de soustracteurs 23 et 24 à la masse en passant respectivement par les enroulements 11 et 12. Les bornes de sortie des soustracteurs 23 et 24 aboutissent respectivement aux entrées d'un sommateur 25 dont la sortie bifurque vers un système de traitement 26 et vers une entrée d'un détecteur synchrone 27. La borne négative du soustracteur 24 est reliée à la masse par une résistance fixe 29, mais celle du soustracteur 23 l'est par l'intermédiaire d'une résistance variable 28 qui est asservie au détecteur synchrone 27. Enfin, le dispositif excitateur 13 fournit un signal de référence à la fréquence d'excitation à une autre entrée du détecteur synchrone 27 par un déphaseur 30 si nécessaire.

Supposons les résistances 28 et 29 égales. Les tensions fournies aux bornes de sortie des soustracteurs 23 et 24 sont alors, à un coefficient de proportionnalité G près, égale à e1+u1 et e2-u2 respectivement, et la tension à la sortie du sommateur 25 est égale à G (e1+u1+e2-u2). Toutefois, le détecteur synchrone 27 distingue la composante à la fréquence d'excitation et ajuste la résistance variable 28 pour modifier le coefficient de proportionnalité à la sortie du soustracteur 23 à une valeur G' telle que G'u1=Gu2. Ainsi, la tension délivrée au système de traitement 26 devient égale à G'e1+Ge2 et peut être exploitée utilement. Aucun autre traitement n'est nécessaire. Cette correction revient en fait à rétablir la symétrie des enroulements 11 et 12.

## Revendications

1. Magnétomètre comprenant un noyau magnétique (1), au moins un bobinage actif (4, 5) et un bobinage récepteur (10), le bobinage actif étant agencé de façon à créer un champ magnétique d'excitation dans le noyau, le bobinage récepteur ayant deux enroulements (11, 12), des moyens de passage (13) d'un courant alternatif à une fréquence d'excitation dans le bobinage actif et des moyens de mesure (14) d'une tension induite dans le bobinage récepteur (10), **caractérisé en ce que** les moyens de mesure (14) comprennent un détecteur (27) d'une composante synchrone à la fréquence d'excitation de la tension induite, un circuit à deux boucles (21, 22) dont chacune comprend un enroulement du bobinage récepteur, un sommateur (25) de tensions partielles aux bornes des deux boucles et un dispositif de correction (28) d'une desdites tensions partielles, asservi audit détecteur.

2. Magnétomètre suivant la revendication 1, **caractérisé en ce que** le dispositif de correction (28) est une résistance variable.

## Patentansprüche

1. Magnetometer, einen Magnetkem (1), wenigstens eine aktive Spule (4, 5) und eine Empfangsspule (10) umfassend, wobei die aktive Spule so angeordnet ist, dass sie in dem Kern ein Erregungsmagnetfeld erzeugt, und die Empfangsspule zwei Wicklungen (11, 12) hat, sowie Einrichtungen (13) zum Einspeisen eines Wechselstroms mit einer Erregungsfrequenz in die aktive Spule und Messeinrichtungen (14) einer in der Empfangsspule (10) induzierten Spannung umfassend,
**dadurch gekennzeichnet, dass** die Messeinrichtungen (14) einen Detektor (27) einer zu der Erregungsfrequenz der induzierten Spannung synchronen Komponente, eine Schaltung mit zwei Schleifen (21, 22), von denen jede eine Wicklung der Empfangsspule enthält, einen Summierer (25) von Partialspannungen an den Anschlüssen der beiden Schleifen und eine von dem genannten Detektor abhängige Korrektureinrichtung (28) von einer der genannten Partialspannungen umfassen.

2. Magnetometer nach Anspruch 1, **dadurch gekennzeichnet, dass** die Korrektureinrichtung (28) ein variabler Widerstand ist.

## Claims

1. Magnetometer comprising a magnetic core, at least one active coil (4, 5) and a receiver coil (10), the active coil being arranged so as to create a magnetic excitation field in the core, the receiver coil having two windings (11, 12), means of passing an alternating current at an excitation frequency in the active coil and means (14) of measuring a voltage induced in the receiver coil (10), **characterized in that** the measurement means (14) comprise a detector (27) of a synchronous component at the excitation frequency of the induced voltage, a circuit with two loops (21, 22) each of which comprises a winding of the receiver coil, an adder (25) of partial voltages at the terminals of the two loops and a device for correction (28) of one of the said partial voltages, slaved to the said detector.

2. Magnetometer according to claim 1, **characterized in that** the correction device (28) is a variable resistance.
